# EUROPEAN PATENT APPLICATION

(11) **EP 4 120 338 A1**
(43) Date of publication of application: **18.01.2023**
(21) Application number: 20924896.2
(22) Date of filing: 16.12.2020
(51) Int. Cl.: H01L 23/473, H01L 25/07, H01L 25/18, H02M 3/28, H02M 7/48

(54) **POWER CONVERSION UNIT AND POWER CONVERSION DEVICE**

(30) Priority: 10.03.2020 JP 2020040586
(71) Applicant: Hitachi, Ltd., Tokyo 100-8280 (JP)
(72) Inventor: MOTEKI, Ryou, Tokyo 100-8280 (JP); AMOU, Satoru, Tokyo 100-8280 (JP); YOSHITAKE, Yuuichirou, Tokyo 100-8280 (JP)
(74) Representative: MERH-IP Matias Erny Reichl Hoffmann Patentanwälte PartG mbB
(86) International application number: PCT/JP2020/046878
(87) International publication number: WO 2021/181789

(57) **Abstract**

This power conversion unit (U) of the present invention comprises a cooling path (11) arranged between an input side power conversion unit (14) and an output side power conversion unit (15) that are divided into one side and another side and installed facing each other. The input side power conversion unit (14) and the output side power conversion unit (15) comprise: a mold resin (9) that is filled in a space (p) inside cases (5a, 5b) in which wiring boards (2) are arranged; switching elements (1) covered by the mold resin (9) provided inside the spaces (p); upper electrode plates (7) connected to the switching elements (1) and covered by the mold resin (9); heat dissipation plates (12) with insulating properties that are connected to the upper electrode plates (7), and covered by the mold resin (9); and lower electrodes (8) provided in contact with or in close proximity to the cooling path (11). The heat dissipation plates (12) are wider than the upper electrode plates (7), and the upper electrode plates (7) are arranged closer to the center away from the edges of the heat dissipation plates (12).

## Description

### Technical Field

The present invention relates to a power conversion unit and a power conversion device.

### Background Art

With the recent increase in the awareness of global warming issues, hybrid automobiles powered by a combination of engine and motor and electric vehicles rapidly proliferate as an electrical vehicle designed for the purpose of CO₂ emission reduction. The electrification of automobiles replaces the engine requiring a fossil fuel with the motor. The CO₂ emission is reduced by not using the fossil fuel, which contributes to reducing global warming.

In a case where the motor is used as power source, an electric power conversion device is necessary for controlling the rotation of the motor. The power conversion device is indispensable for enhancing an operation efficiency of the motor in the hybrid automobiles, electrical vehicles, and other products. If the motorized electrification continues in various fields, a use environment for the power conversion device begins to change. For example, if the use environment for the power conversion device is increased in altitude, the atmospheric pressure lowers.

It is known from Paschen's Law that the insulation performance of a gaseous body degrades due to a decrease in the atmospheric pressure. The gaseous body degraded in the insulation performance is prone to induce partial discharge, which induces insulation breakdown. To enhance the reliability of the power conversion device, therefore, it is necessary to take a measure against the partial discharge even under low pressure environment. Further, the power conversion device is also required to dissipate heat during operation because electronic components including switching elements, power modules and the like generate heat during operation.

Arrangement methods of heat dissipation plates for improving the heat dissipation of the switching elements and the power module are disclosed in Patent Literatures 1 and 2.

### Citation List

### Patent Literature

Patent Literature 1: Japanese Patent Application Laid-Open No.2015-56925 (Paragraph 0010, Fig. 1C etc.)
Patent Literature 2: Japanese Patent Application Laid-Open No.2005-287267 (Paragraph 0014, Fig. 3 etc.)

### Summary of Invention

### Technical Problem

By the way, Patent Literature 1 is directed to achieve three objects which include: suppression of surge voltage; high heat dissipation; and suppression of ringing. As a measure for the high heat dissipation, heat dissipation plates (heat dissipation plates 3h, 4h in Fig. 1C of Patent Literature 1) are connected to the switching elements.

According to Patent Literature 2, dissipation plates made of a conductor (cooling substrates 10b in Fig. 2 of Patent Literature 2) are attached to back sides of the power modules for the purpose of reducing floating inductance produced between the power modules. While both Patent Literatures 1, 2 suggest the heat dissipation methods, there is no teaching about the measure against the partial discharge under low pressure environment. The devices of Patent Literatures 1, 2 have different configurations from that of a subject matter of the present invention. Therefore, the object of the invention is not solved by means the disclosures of the above patent literatures, requiring a novel method.

In view of the above-described related art, the present invention has been created. An object of the invention is to provide a power conversion unit and a power conversion device which are adapted to suppress the partial discharge under low pressure environment.

### Solution to Problem

For achieving the above object, a power conversion unit includes a cooling path disposed between an input-side power conversion part and an output-side power conversion part separately disposed on one side and the other side in opposed relation, wherein the input-side power conversion part and the output-side power conversion part each include: a mold resin filled in a space inside a case provided with a wiring board; switching elements disposed in the space and covered with the mold resin; upper electrode plates connected to the switching elements and covered with the mold resin; heat dissipation plates having insulation properties, connected to the upper electrode plates and covered with the mold resin; and a lower electrode plate disposed in contact with or in proximity to the cooling path, and has an arrangement wherein the heat dissipation plates are wider than the upper electrode plates, and the upper electrode plates are disposed closer to the center as spaced away from the peripheries of the heat dissipation plates.

### Advantageous Effects of Invention

The present invention can provide the power conversion unit and the power conversion device which are adapted to suppress the partial discharge under low pressure environment.

### Brief Description of Drawings

Fig. 1A is a perspective view of a power conversion unit according to a first embodiment of the present invention;
Fig. 1B is a sectional view of the power conversion unit according to the first embodiment as taken on the line I-I in Fig. 1A;
Fig. 2 is a view of the mounted switching element, upper electrode plate and heat dissipation plate taken along the arrowed line I-I in Fig. 1A;
Fig. 3 is a sectional view taken on the line I-I in Fig. 1A for showing another example of the power conversion unit according to the first embodiment;
Fig. 4 is a diagram showing the power conversion unit of the first embodiment divided into an input-side unit and an output-side unit;
Fig. 5 is a view equivalent to the sectional view taken on the line I-I in Fig. 1A, for showing a power conversion unit according to a second embodiment hereof;
Fig. 6 is a view equivalent to the sectional view taken on the line I-I in Fig. 1A, for showing a power conversion unit according to a third embodiment hereof;
Fig. 7 is a view equivalent to the sectional view taken on the line I-I in Fig. 1A, for showing a power conversion device according to a fourth embodiment hereof; and
Fig. 8 is a diagram showing an example of a circuit K according to a fifth embodiment, which is applied to the power conversion units according to the first to fourth embodiments.

### Description of Embodiments

Preferred embodiments for carrying out the invention will hereinbelow be described with reference to the accompanying drawings. It is noted here that the following embodiments are intended for purposes of illustration only and are not intended to limit the subject-matter of the invention to be following specific embodiments. As a matter of course, a variety of changes and modifications can be made to the invention including the following embodiments.

### First Embodiment

As for a first embodiment, the description is made on a power conversion unit where a heat dissipation plate having insulation properties is connected to an upper electrode plate.

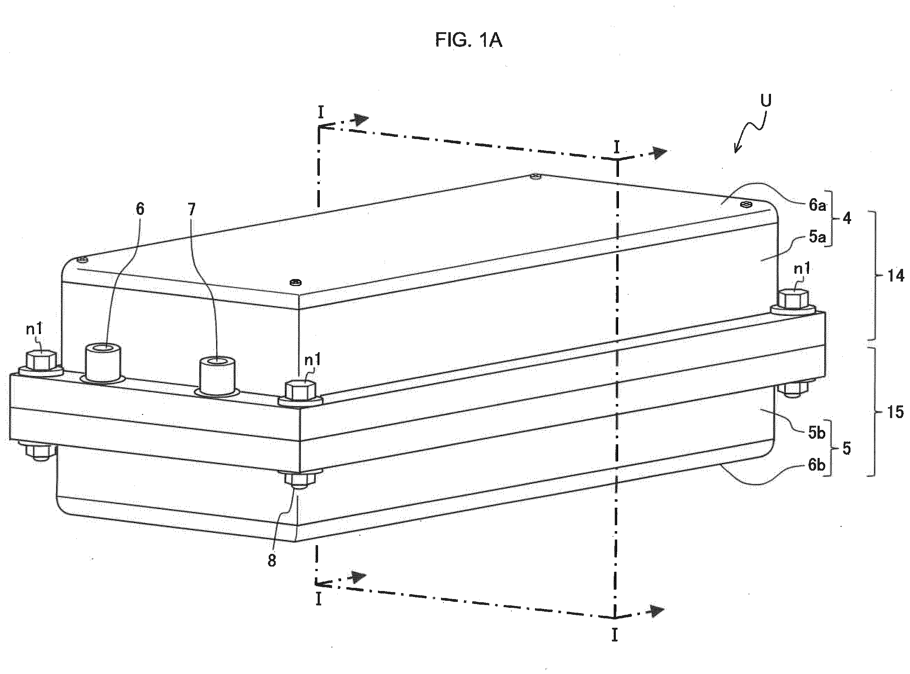

Fig. 1A is a perspective view of a power conversion unit U according to the first embodiment of the invention.

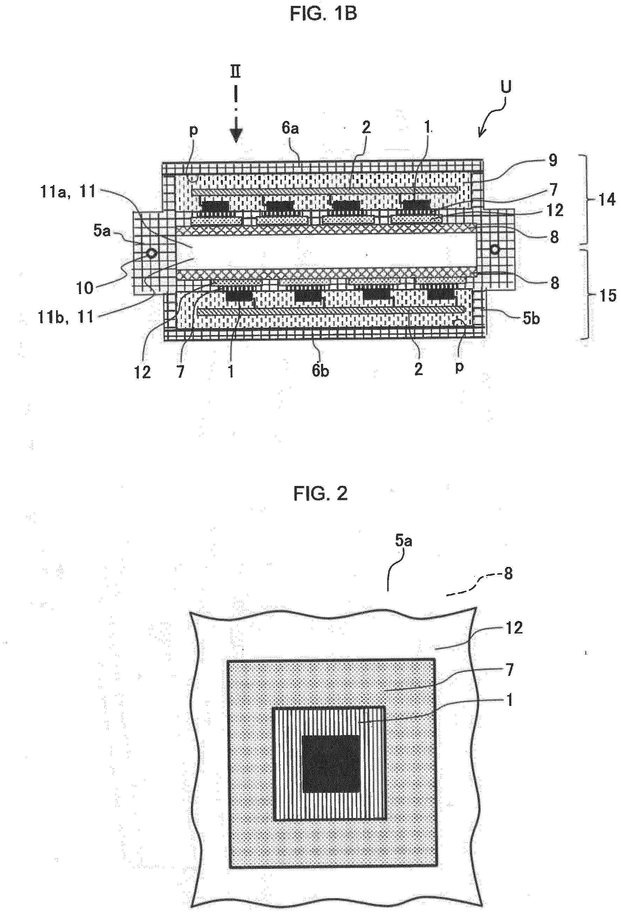

Fig. 1B is a sectional view of the power conversion unit U according to the first embodiment as taken on the line I-I in Fig. 1A.

The power conversion unit U of the first embodiment includes: an input-side unit (an input-side power conversion part) 14 on an input side of the unit U, and an output-side unit (output-side power conversion part) 15 on an output side of the unit U.

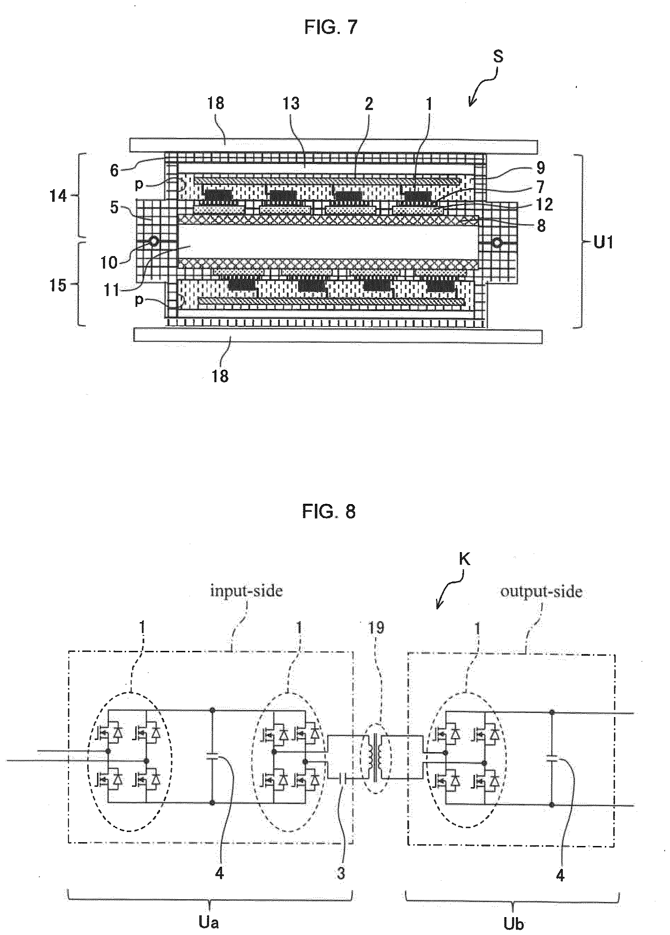

The power conversion unit U includes: switching elements 1 (see Fig. 1B); a wiring board 2; a resonant capacitor 3 (see Fig. 8); a smoothing capacitor 4 (see Fig. 8); cases 5a, 5b; case lids 6a, 6b; and components compatible therewith. The power conversion unit U has a contour defined by an outer shell formed of the input-side case 5a and case lid 6a, and the output-side case 5b and case lid 6b.

An input-side unit 14 and an out-side unit 15 have the same configuration. Therefore, like reference characters of the input-side unit 14 refer to corresponding structural components of the output-side unit 15 and the description thereof is dispensed with.

The power conversion unit U shown in Fig. 1B has a wiring board 2 disposed internally in the input-side case 5a and case lid 6a and in the output-side case 5b and case lid 6b respectively. Mounted on the wiring board 2 are the switching elements 1, the resonant capacitors 3 (see Fig. 8), the smoothing capacitors 4 (see Fig. 8) and the like.

As shown in Fig. 1B, all the switching elements 1 are connected to upper electrode plates 7.

The upper electrode plates 7 are connected with heat dissipation plates 12 having the insulation properties. The heat dissipation plate 12 has the insulation properties and good heat conductivity. The heat dissipation plate 12 is defined to be wider than the upper electrode plate 7 (having a larger area). Therefore, heat transferred from the upper electrode plate 7 to the heat dissipation plate 12 is spread across the wide heat dissipation plate 12 and released. Thus, the switching element 1 is improved in heat removal properties (The details will be described hereinlater).

In the power conversion unit U, the power conversion part having a power conversion function is divided into the input-side unit 14 on one side thereof and the output-side unit 15 on the other side thereof. The input-side unit 14 and the out-side unit 15 are arranged in opposed relation. A cooling path 11 is laid in space defined between the input-side unit 14 and the output-side unit 15 in opposed relation. The cooling path 11 is formed of an input-side cooling path 11a and an output-side cooling path 11b.

A cooling medium for cooling these units 14, 15 flows through the cooling path 11.

An O-ring 10 is interposed between the input-side unit 14 and the output-side unit 15 such as to prevent the leakage of the cooling medium from the cooling path 11 between the input-side unit 14 and the output-side unit 15. The intervention of the O-ring 10 is effective at preventing the leakage of the cooling medium from between the input and output side units 14, 15.

Both the input-side unit (the upper side as seen in Fig. 1B) and the output-side unit (the lower side as seen in Fig. 1B) are each provided with a lower electrode plate 8 on their sides in contact with the cooling path 11. It is noted that the lower electrode plate 8 can also be disposed in proximity to the cooling path 11. The lower electrode plate 8 is at a ground potential.

The heat dissipation plate 12 is disposed adjacent to the lower electrode plate 8. The upper electrode plate 7 is disposed adjacent to the heat dissipation plate 12. The switching element 1 is electrically and thermally connected to the upper electrode plate 7. A terminal of the switching element 1 is connected to the upper electrode plate 7. The switching element 1 is a heat generating component which is in contact with the upper electrode plate 7 for heat conduction. The heat of the switching element 1 is conducted to the heat dissipation plate 12 having the insulation properties via the upper electrode plate 7 and is removed by heat exchange with the cooling medium.

Fig. 2 is a view of the mounted switching element 1, upper electrode plate 7 and heat dissipation plate 12 taken along the arrowed line II in Fig. 1B. The upper electrode plate 7 is wider than the switching element 1 which is disposed centrally of the upper electrode plate 7. Similarly, the heat dissipation plate 12 is wider than the upper electrode plate 7 (or has a larger area). The upper electrode plate 7 is disposed closer to the center as spaced away from the peripheries of the heat dissipation plate 12. Accordingly, a creepage distance between the upper electrode plate 7 ad the lower electrode plate 8 (see Fig. 1B). is increased so that insulation performance between the upper electrode plate 7 and the lower electrode plate 8 is improved.

This ensures the insulation performance of the input side (the upper side as seen in Fig. 1B) and the output side (the lower side as seen in Fig. 1B) of the power conversion part, and also facilitates the dissipation of heat from the switching elements 1 to the cooling path 11.

While alumina is used as a material of the heat dissipation plate 12 of the first embodiment, the material is not particularly limited so long as such a material has the insulation properties and high heat dissipation performance. But for alumina, examples of a usable material of the heat dissipation plate 12 include: inorganic materials such as aluminum nitride and silicon nitride; and organic materials such as epoxy resins containing alumina or aluminum nitride.

In addition to the switching elements 1, electronic components such as a resonant capacitor 3 and a smoothing capacitor 4 are mounted on a wiring board 2 for power conversion, as shown in Fig. 8 which will be described hereinlater.

A mold resin 9 such as silicone gel is filled in a space p of the input-side unit 14 (the upper side as seen in Fig. 1B) and the output-side unit 15 (the lower side as seen in Fig. 1B) where the switching elements 1, the wiring board 2, the resonant capacitors 3, the smoothing capacitors 4, the upper electrode plates 7 and the like are arranged and insulated with solid. The mold resin 9 is not particularly limited so long as the resin is mobile in an uncured state but becomes non-fluid when cured. Examples of a suitable mold resin 9 include silicone resins and epoxy resins.

The heat dissipation plate 12 having the insulation properties is molded integrally with the case 5a, 5b. The fabrication of the power conversion unit U is facilitated by integrally molding the heat dissipation plate and the case, resulting in a shortened fabrication process of the power conversion unit U. While PPS (glass fiber reinforced polyphenylene sulfide) is used for molding the input-side and output-side cases 5a, 5b and the input-side and output-side case lids 6a, 6b, the material is not particularly limited. Examples of other material for molding the cases 5a, 5b and the case lids 6a, 6b include ABS resins, polyamide, epoxy resins, unsaturated polyester resins and the like. For the purpose of preventing separation from adjoining components or producing cracks therein, a linear coefficient of expansion of the case material may preferably be close to those of the upper electrode plate 7, the lower electrode plate 8 and the heat dissipation plate 12.

The inside of the case 5a, 5b where the wiring board 2 is mounted is insulated with solid by filling the mold resin such as silicone gel in the space p of the case 5a, 5b. By doing so, the insulation properties of the internal space p can be maintained in spite of the drop in air pressure. Therefore, partial discharge from the electronic components such as the switching elements 1 mounted on the wiring board 2 can be suppressed.

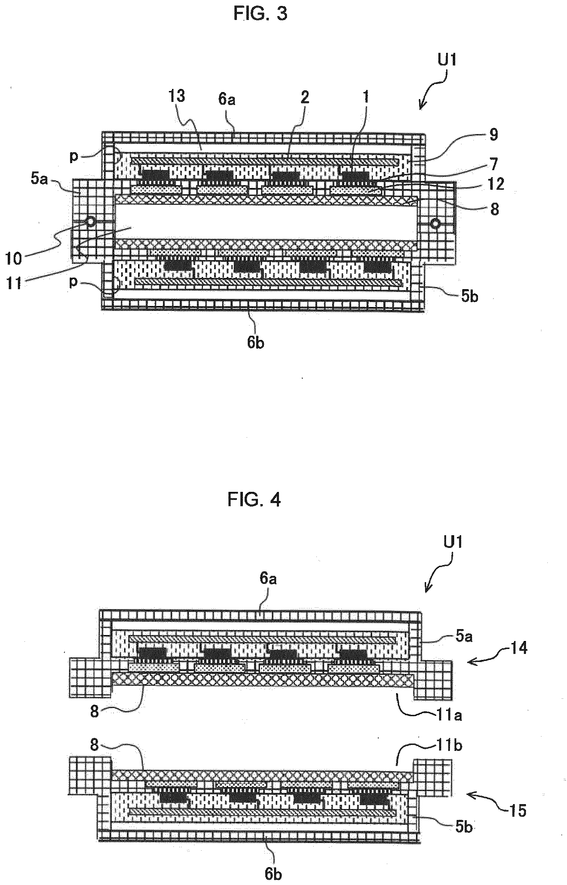

Fig. 3 is a sectional view taken on the line I-I in Fig. 1A, illustrating a power conversion unit U1 according to another example of the first embodiment. The power conversion unit U1 of the other example has a configuration where an unfilled part 13 free of the mold resin 9 is formed in the space p where the wiring board 2 is disposed. The other components are the same as those of the power conversion unit U shown in Fig. 1A and Fig. 1B and hence, are referred to by like reference numerals.

In the power conversion unit U1, an uncured mold resin 9 is poured into both the input-side and the output-side cases from a wiring board 2 side and is allowed to react for solidification. In the process, the unfilled part 13 is formed by pouring the mold resin 9 less than needed.

Accordingly, if the mold resin 9 such as silicone gel is expanded by heat generated by the switching elements 1, the unfilled part 13 can accommodate the expansion of the mold resin 9. Thus, the breakage of the mold resin 9 can be prevented.

Fig. 4 is a diagram showing the power conversion unit of the first embodiment in a disassembled state.

The power conversion unit U is configured to be divided into the input-side unit 14 and the output-side unit 15. The input-side unit 14 and the output-side unit 15 are secured to each other by means of a bolt nl (see Fig. 1A) while clamping the O-ring 10 therebetween.

That is, each of the input-side unit 14 and the output-side unit 15 can be subjected to an insulation test. In the case of defective insulation or at the time of maintenance work, therefore, only the defective parts need be disposed of. This leads to waste reduction.

### Second Embodiment

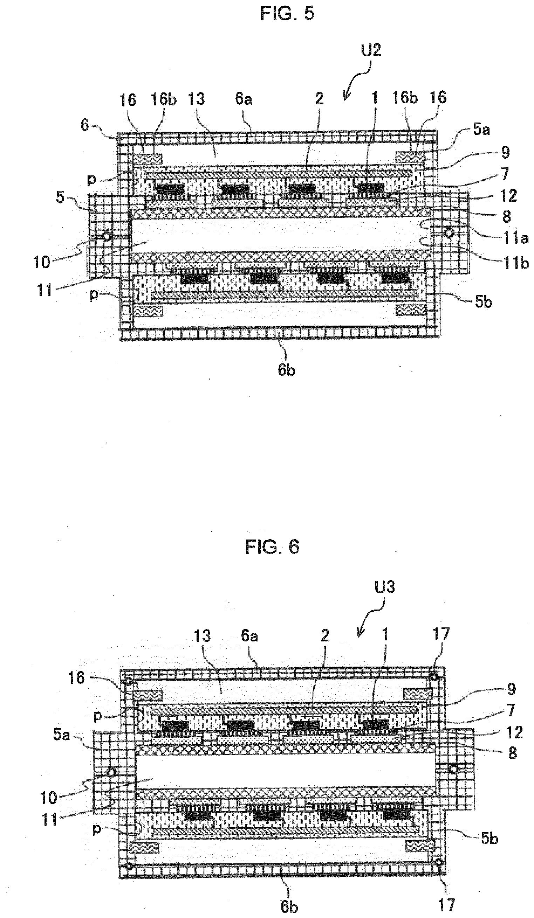

Fig. 5 is a view equivalent to the sectional view taken on the line I-I in Fig. 1A, for illustrating a power conversion unit U2 according to a second embodiment hereof.

The power conversion unit U2 of the second embodiment has a configuration where hygroscopic agents 16 such as silica gel are disposed in the unfilled part 13. The other components are the same as those the power conversion unit U1 according to the other example shown in Fig. 3. Hence, like reference numerals refer to the like components, a detailed description of which is dispensed with.

The power conversion unit U2 includes an area 16b accommodating the hygroscopic agents 16 such as silica gel in the same space as the space p where the mold resin 9 such as silicone gel is filled. Specifically, the unfilled part 13 is provided with the area 16b to accommodate the hygroscopic agents 16 therein.

By virtue of the hygroscopic agents 16 adsorbing the moisture in the space p, moisture absorption by the mold resin 9 such as silicone gel 9 can be suppressed. Hence, the mold resin 9 can maintain its the insulation properties.

Therefore, the mold resin 9 maintains its the insulation properties so that the power conversion unit can maintain the effect to prevent the partial discharge.

### Third Embodiment

Fig. 6 is a view equivalent to the sectional view taken on the line I-I in Fig. 1A, for illustrating a power conversion unit U3 according to a third embodiment hereof.

A power conversion unit U3 according to the third embodiment is configured to maintain air-tightness of the space p where the wiring board 2 is disposed. The other components are the same as those of the power conversion unit U1 of the other example shown in Fig. 3. Hence, the other components are referred to by like reference numerals, a detailed description of which is dispensed with.

The power conversion unit U3 includes an O-ring 17 disposed at place where the input-side case 5a and case lid 6a join together and an O-ring 17 is similarly disposed at place where the output-side case 5b and case lid 6b join together.

The air-tightness of the internal spaces p between the input-side and output-side cases 5a, 5b and the input-side and output-side case lids 6a, 6b is enhanced by interposing the O-rings 17 between the case lids 6a, 6b and the cases 5a, 5b, respectively.

Therefore, the moisture flow into the power conversion unit U3 can be inhibited. Accordingly, the mold resin 9 maintains the insulation properties, resulting in unchanged deterrent effect on the partial discharge.

### Fourth Embodiment

Fig. 7 shows a view equivalent to the sectional view taken on the line I-I in Fig. 1A, for illustrating a power conversion device S according to a fourth embodiment.

The fourth embodiment illustrates a configuration of the power conversion device S to which the power conversion unit U1 is applied.

The power conversion device S of the fourth embodiment includes an inboard frame 18 disposed on the power conversion unit U1 (Fig. 2) .

The power conversion device S is provided with the grounded inboard frame 18 on the outer sides of the input-side unit 14 and the output-side unit 15. Because of the grounded inboard frames 18, electric shock upon contact with the power conversion device S can be avoided.

The power conversion unit U1 is not only usable as a single unit but two or more conversion units can also be used as interconnected and mounted on the inboard frame 18. In the case of a high-voltage power conversion device S where a plurality of the power conversion units U1 are interconnected and mounted on the inboard frame 18, the electric shock upon contact with the power conversion device S can be avoided.

It goes without saying that the above-described power conversion units U, U2, U3 are applicable to the power conversion device S.

### Fifth Embodiment

Fig. 8 shows an example of a circuit K according to a fifth embodiment hereof.

The fifth embodiment illustrates the circuit K for use in the power conversion units U to U3 according to the first to the third embodiments hereof.

The input-side unit 14 on the input side and the output-side unit 15 on the output side, as shown in Fig. 1B, are provided with the switching elements 1 and the smoothing capacitors 4. Applicable to the switching element 1 are, for example, IGBT (Insulated Gate Bipolar Transistor), MOSFET (metal-oxide-semiconductor field-effect transistor), GaN, Si, SiC and the like.

The resonant capacitor 3 is disposed at the input-side unit 14. The input side and the output side units are interconnected via a high-frequency transformer 19.

The resonant capacitor 3 is disposed at the input-side unit 14. The input-side unit and the output-side unit are interconnected via a high-frequency transformer 19.

The above-described configuration provides the following advantages. In the power conversion units U to U3, the partial discharge can be suppressed by filling the mold resin 9 such as silicone gel in the space p where the wiring board 2 is disposed.

The insulation between the upper electrode plate 7 and the lower electrode plate 8 and the good heat dissipation therefrom can both be accomplished by disposing the upper electrode plate 7 in contact with the heat dissipation plate 12 which is wider than the upper electrode plate 7 and has the insulation properties.

By virtue of the cooling path 11 disposed between the input-side unit 14 and the output-side unit 15 of the power conversion part, the electronic components such as the switching elements 1 of the input-side unit 14 and the output-side unit 15 can be cooled by the single cooling path 11. Namely, even in an environment of high altitude and low atmospheric pressure, the power conversion units U to U3 can support both an insulation structure free from the partial discharge and a heat dissipation structure for dissipating heat from the switching elements 1.

### Other Embodiments

1. The power conversion units U o U3 described in the foregoing embodiments are used as a converter.
2. While a variety of configurations have been described in the foregoing embodiments and the like, any of the components of these configurations can be used in combination as needed to form a structure.
3. It is noted that the configurations illustrated by the above embodiments are meant only for an example and a variety of modes and modifications can be made within the scope of the invention.

### Reference Signs List

1: switching element,
2: wiring board,
3: resonant capacitor
4: smoothing capacitor
5a, 5b: case
6a, 6b: case lid
7: upper electrode plate
8: lower electrode plate (lower electrode)
9: mold resin
10: O ring (second sealing material)
11: cooling path
12: heat dissipation plate
13: unfilled part (unfilled space)
14: input-side unit (input-side power conversion part)
15: output-side unit (output-side power conversion part)
16: hygroscopic agents
17: case lid O-ring (first sealing material)
18: inboard frame (frame)
19: high-frequency transformer
P: space
U, U1, U2, U3, U4: power conversion unit
S: power conversion device

## Claims

1. A power conversion unit comprising a cooling path disposed between an input-side power conversion part and an output-side power conversion part separately disposed on one side and the other side in opposed relation, wherein
the input-side power conversion part and the output-side power conversion part each include:
a mold resin filled in a space inside a case provided with a wiring board;
switching elements disposed in the space and covered with the mold resin;
upper electrode plates connected to the switching elements and covered with the mold resin;
heat dissipation plates having insulation properties, connected to the upper electrode plates and covered with the mold resin; and
a lower electrode plate disposed in contact with or in proximity to the cooling path, and wherein
the heat dissipation plates are wider than the upper electrode plates; and
the upper electrode plates are disposed closer to the center as spaced away from the peripheries of the heat dissipation plates.

2. The power conversion unit according to Claim 1, wherein
the input-side power conversion part and the output-side power conversion part are formed in split structures.

3. The power conversion unit according to Claim 1, wherein
the lower electrode is at a ground potential.

4. The power conversion unit according to Claim 1, wherein
IGBT, MOSFET, GaN, Si or SiC is used for the switching element.

5. The power conversion unit according to Claim 1, wherein
an unfilled space free from the mold resin is formed in the space.

6. The power conversion unit according to Claim 5, wherein hygroscopic agents are placed in the unfilled space.

7. The power conversion unit according to Claim 1, wherein
the heat dissipation plate is molded integrally with the case.

8. The power conversion unit according to Claim 1, wherein
a first sealing material is interposed between the case and a case lid secured to the case.

9. The power conversion unit according to Claim 2, wherein
a second sealing material is interposed between the input-side power conversion part and the output-side power conversion part.

10. A power conversion device comprising the power conversion unit according to any one of Claims 1 to 9, further comprising a frame which is connected to each of the case lids fixed to the cases of the input-side power conversion part and the output-side power conversion part and which is grounded.
